# EUROPEAN PATENT APPLICATION

(11) **EP 1 354 979 A1**
(43) Date of publication of application: **22.10.2003**
(21) Application number: 01955636.4
(22) Date of filing: 09.08.2001
(51) Int. Cl.: C23C 14/24, H05B 33/10, H05B 33/14

(54) **METHOD AND DEVICE FOR PRODUCING ORGANIC EL ELEMENTS**

(30) Priority: 10.08.2000 JP 2000242164; 28.06.2001 JP 2000196679
(71) Applicant: Nippon Steel Chemical Co., Ltd., Tokyo 141-0031 (JP); Osaka Yuka Industries Co., Ltd., Hirakata-shi, Osaka 573-0136 (JP); Seta Giken Co., Ltd., Osaka 567-0862 (JP)
(72) Inventor: Ishii, Kazuo c/o R. & D. Lab. Nippon Steel Co.Ltd, Kitakyushu-shi Fukuoka 804-8503 (JP); Miyazaki, Hiroshi c/o R.&D.Lab. Nippon Steel Co.L, Kitakyus hu-shi Fukuoka 804-8503 (JP); Hotta, Shuhei c/o Osaka Yuka Industries Co., Ltd., Hirakata-shi, Osaka 573-0136 (JP); Uchihori, Yoshitaka, Ibaraki-shi, Osaka 567-0862 (JP)
(74) Representative: Hague, Alison Jane
(86) International application number: JP0106874
(87) International publication number: WO02014575

(57) **Abstract**

This invention relates to a method for producing vapor-deposited films of good quality for organic El elements uniformly and rapidly in high productivity by electromagnetic induction heating of a container to which the raw material is introduced. The device of this invention for vapor deposition of films for organic EL elements vaporizes an organic material 5 in a container 2 and deposits the material in thin film on the surface of a film-forming substrate 6 and comprises a container 2 constructed of a material capable of generating heat by electromagnetic induction and a means for heating said container by electromagnetic induction. This invention also relates to a method for producing organic EL elements by the use of said device. It is possible to introduce the organic material to said container 2 constructed of a material capable of generating heat by electromagnetic induction or to introduce the organic material together with a filling up structure constructed of a material capable of generating heat by electromagnetic induction.

## Description

### Field of Technology

This invention relates to a device for producing organic electroluminescent elements (organic EL elements) and, more particularly, to a method for vaporizing an organic EL material for the vacuum deposition of a thin organic film for use in an organic EL element and to a device for said method.

### Background Technology

An organic EL element is generally constructed of thin organic layers such as a hole transport layer, a light-emitting layer and an electron transport layer arranged between an anode and a cathode respectively composed of a transparent electrically conductive film and emits light when a hole injected into the light-emitting layer from the anode via the hole transport layer unites again with an electron injected into the light-emitting layer from the cathode via the electron transport layer. The problem of a variation in the performance of EL elements would arise if the organic thin films constituting the hole transport layer, light-emitting layer and electron transport layer vary in thickness and composition from lot to lot in vapor deposition due to an unstable rate of vaporization.

Vacuum deposition is known to be one of the techniques used for the production of organic thin films for use in organic EL elements as described in JP2000-68055 A and elsewhere. According to this technique, a material for vapor deposition vaporizes from the vaporization source that is heated above the vaporization temperature of the material and deposits as solid on the surface of a film-forming substrate to form a thin film.

As for the method of heating the vaporization source, indirect heating and direct resistance heating are known ; according to the latter method, an electric current is passed through a metallic container (a metallic boat) of relatively high electrical resistance and the heat generated by resistance is utilized for heating as described in Appl. Phys. Lett. 68 (16), 15 April 1996 and JP2000-68055 A.

In direct resistance heating, a container of high electrical resistance fabricated from a thin plate of a metallic material of high melting point such as tungsten, tantalum and molybdenum is generally used. For uniform heating of the whole container, the container should be fabricated in such a shape as to allow the current to flow in uniform distribution. If the container has an elongated shape like a boat, the current can be distributed relatively uniformly by providing terminals at both ends of the elongated axis ; however, even this arrangement still creates a difference in temperature between the central part and the terminal parts and, besides, a boat-shaped container limits the amount of the material to be fed and is not suitable for mass production.

A container shaped like a crucible is suitable for securing a sufficient amount of the material to be fed ; however, if direct resistance heating is applied by providing terminals in a crucible, it is difficult to pass the current uniformly throughout the crucible in order to attain uniform heating of the whole crucible. As a result, a temperature distribution would be formed in the crucible ; the temperature would drop below the target temperature to cause no vaporization of the material for vapor deposition in the regions where the current density is low while the temperature would locally rise excessively to cause not only vaporization of the material in excess of the specified amount but also thermal decomposition of the material in the regions where the current density is high, possibly changing the quality of the organic thin film to be formed.

When a material is fed to a crucible-shaped container in mass production, a method generally used for attaining uniform heating of the container is not the aforementioned direct resistance heating but indirect heating from a separately installed resistance heater. However, this type of indirect heating is poor in heat response and the amount of vaporization becomes difficult to control. That is, when the temperature is below the target temperature, the material does not vaporize in a sufficient amount and the film formed becomes thinner than specified. On the other hand, when the temperature is allowed to exceed the target temperature, not only the film formed becomes too thick but also the organic material undergoes thermal decomposition leading to a change in quality of the organic thin film. Moreover, the time required for the temperature to rise from the start of heating to the target temperature at which stable production of the organic thin film starts is longer in indirect heating than in direct heating and loss in time and raw material is incurred in the meantime. At any rate, it is necessary to devise a procedure for prevention of vapor deposition on the substrate by the use of a shutter and the like until the rate of vaporization stabilizes and the aforementioned loss occurs on many occasions.

### Disclosure of the Invention

This invention provides a device which can heat a raw material for vapor deposition uniformly and rapidly with good heat response and temperature control and provides a method for producing a deposited film of good quality suitable for use in organic EL elements in high yield and productivity.

In a method for vapor deposition wherein an organic material for organic EL elements is vaporized and deposited on a film-forming substrate to form a thin film, this invention relates to a method for producing organic EL elements which comprises introducing the aforementioned organic material to a container at least partly constructed of a material capable of generating heat by electromagnetic induction heating and heating said container directly by electromagnetic induction thereby vaporizing said organic material.

Furthermore, in vapor deposition wherein an organic material for organic EL elements in a container is vaporized and deposited on a film-forming substrate to form a thin film, this invention relates to a device for vapor deposition to form a thin film for organic EL elements which comprises the aforementioned container constructed of a material capable of generating heat by electromagnetic induction and a means for heating the aforementioned container by electromagnetic induction to vaporize the aforementioned organic material.

Still further, this invention relates to a device for vapor deposition to form a thin film for organic EL elements which comprises a container charged with a mixture of an organic material and a filling up structure (or filler) at least partly made of a material capable of generating heat by electromagnetic induction and a means for heating the aforementioned filling up structure by electromagnetic induction to vaporize said organic material and to a method for producing organic EL elements which comprises vaporizing the organic material by the use of said device. In this case, it is also preferable that the container is at least partly constructed of a material capable of generating heat by electromagnetic induction.

### Brief Description of the Drawings

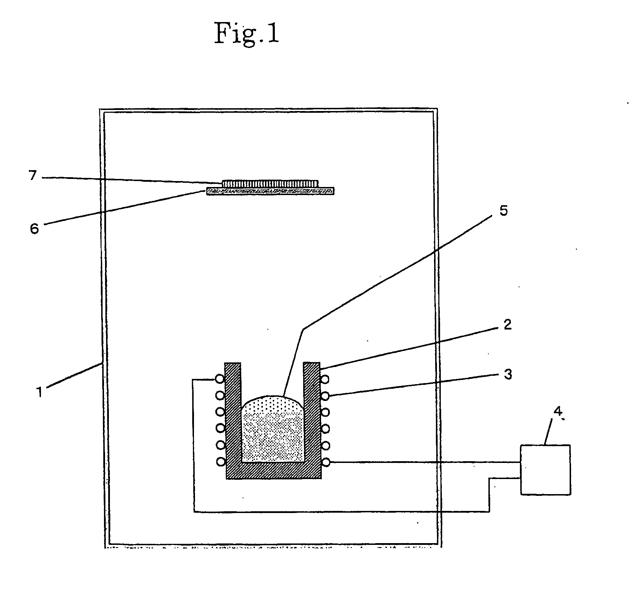

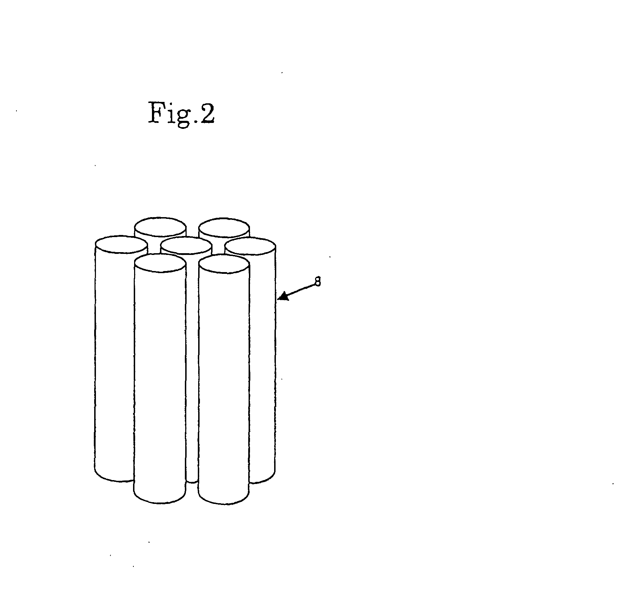

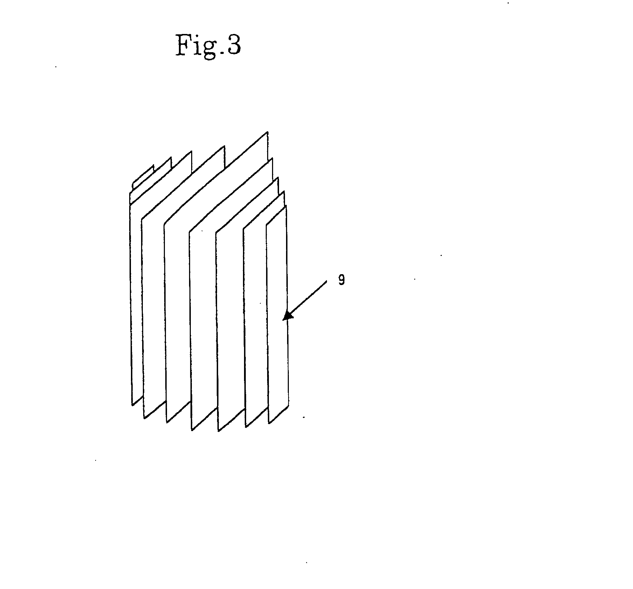

Fig. 1 is a schematic cross section of a device for vapor deposition to form a thin film for organic EL elements. Fig. 2 is a perspective view of a filling up structure (filler) and Fig. 3 is a perspective view of a filling up structure of another kind.

### Preferred Embodiments of the Invention

The device of this invention for vapor deposition to form a thin film for organic EL elements and the method of this invention for vapor deposition will be described in detail below. Fig. 1 is a schematic cross section of an example of the device of this invention. In Fig. 1, the numbers designate the following : 1, chamber ; 2, container ; 3, coil ; 4, power supply device ; 5, organic material ; 6, substrate ; 7, substrate holder. It is to be noted that the main components of the device are placed in the chamber in this example ; however, it is possible to elongate the chamber and install the coil outside the chamber.

The device for vacuum deposition in the aforementioned example is placed in the chamber 1 which can be evacuated and is equipped with the container 2 for introducing the organic material 5, the coil 3 arranged around the container 2, the power supply device 4 connected to the coil 3 and the substrate holder 7 for holding the substrate 6 on which vapor deposition takes place. The chamber 1 is constructed in such a manner as to allow evacuation by a vacuum pump and introduction and withdrawal of the organic material and the substrate.

The container 2 may be shaped normally like a crucible or shaped simply like a cylinder, but it is preferably shaped like a crucible or a modification thereof. Moreover, one of the preferable shapes is the one called cell or Knudsen Cell. In case the container has a large diameter, it is allowable to provide inside the container filling up structure that can be heated by electromagnetic induction. As an example such a material is a wall that can be heated by induction. Although there is no specific restriction on the shape of the container 2, the container should desirably be constructed in a shape that allows rapid and uniform heating of the organic material to be introduced.

In case the container 2 itself is made to function as heat generator, it is constructed of a material which generates heat by electromagnetic induction or it may be constructed of a combination of a heat-generating material and other materials. The heat-generating material is either metallic or nonmetallic and preferably an electrically conductive magnetic material. Preferably, the portion of the container including the bottom and the side which come into contact with the organic material to be introduced is constructed of a material which is capable of generating heat by electromagnetic induction.

In the cases where a material which does not generate heat by electromagnetic induction is used for constructing the container, a filling up structure or filling up structure capable of generating heat by electromagnetic induction may be arranged in the container to serve as source of heat as proposed in JP1991-98286 A and JP1996-264272 A. In this case, it is not always necessary to construct the container of a material capable of generating heat by electromagnetic induction, but it is advantageous from the viewpoint of uniform heating to construct the container of a material capable of generating heat by electromagnetic induction and, further, to arrange a filling up structure capable of generating heat by electromagnetic induction in the container. For example, a large-sized container sometimes causes a problem in respect to uniform temperature control due to formation of a temperature gradient between the organic material in contact with the container wall and the one away from it. An effective way to avoid the problem of this kind and suppress the formation of temperature gradient is to arrange a filling up structure that can be heated by induction in the container and heat the filling up structure or the filling up structure and the container directly by electromagnetic induction.

In order to achieve uniform heating of the aforementioned filling up structure itself by electromagnetic induction, it is important in designing to optimize various factors such as the shape and thickness of the filling up structure, the spacing of the filling up structure, the permeability and electrical conductivity of the filling up structure material and the frequency of the alternating current to be supplied. In view of this, it is advantageous to make a filling up structure in the form of laminas arranged at intervals from a material that can be heated by induction such as a wire netting or to make a large number of small cylinders from a material such as wire netting and a piece of wire and place particles of the organic material around, in the gaps or inside of the laminas or the cylinders. The filling up structure may be a granule, a plate or a lump and not molded in the specified shape.

Supposing a given organic material is used to form a light-emitting layer, the material is often an organic metal complex and when the metal in a complex comes into contact with a metal of a different kind at high temperature, an exchange of metals takes place at a certain rate. As a result, the purity of the complex deteriorates and sometimes drops down to a level which is lower than the purity of the raw material. The purification of metal complexes by sublimation at high temperature is accompanied in most cases by decomposition of the complexes. The ligand formed in the course of decomposition naturally forms a complex with a metal of a different kind when the two come into contact. In the cases where a metallic device is used and the organic material contains acids, sulfur compounds, halogen compounds and the like, it is a matter of concern that these contaminants may corrode the metal of the device or decompose by the catalytic action of the metal to cause contamination of the organic material.

As noted above, the container 2 may be constructed either of one kind of metallic material or a material of 2 layers or more and the container itself does not need to generate heat by electromagnetic induction as long as the filling up structure arranged inside the container generates heat; however, the container is necessarily constructed at least in part of a heat-generating material and, in the aforementioned case where the metallic material contaminates the organic material or changes the quality of the organic material, it is desirable to make the inner surface of the container and the surface of the filling up structure inert to the organic material being vaporized. Ferrous metals such as iron and iron alloys are generally preferred as heat-generating materials and stainless steel, graphite and magnetic ceramics such as titanium nitride can also be used from the viewpoint of heat resistance and corrosion protection. A metal such as iron, when used as heat-generating material, is often not inert to the vaporizing material and to oxygen gas remaining in traces and, in such a case, it is advisable to use a material inert to the organic material and gas in the inner layer (the surface of the area coming into contact with the organic material).

Inert materials of this kind include metals such as noble metals and alloys, heat-resistant resins such as fluoropolymers, polyimides and silicones, glasses such as quartz glass, Pyrex, hard glass and enamel and ceramics such as alumina, silicon nitride and porcelain. Preferable inert materials are metals, glasses such as enamel, fluoropolymers and ceramics. Of the aforementioned materials, those which lack strength or are difficult to form or costly can be applied as inner layer by such means as vapor deposition or plating. Moreover, it is advantageous to use as inner layer a magnetic ceramic material such as titanium nitride which is a heat-generating material as well as an inert material. Still more, in place of a material of a multilayer structure, a container made of a material which is both heat-generating and inert such as SiC, graphite and titanium nitride can be used.

The coil 3 is provided for the purpose of heating the container 2 or the filling up structure by induction and is placed around the container 2. An alternating current is passed through the coil placed around the container to make the container and the filling up structure generate heat. The current to the coil 3 is supplied by the power supply device 4 and the device 4 is connected to a commercial power source and generates an alternating current of the specified frequency. The frequency of the current supplied from the device 4 to the coil 3 is selected suitably from the range of several tens to 100 kHz in consideration of the thickness of the heat-generating body and the penetrating depth of the current and, preferably, it is a high frequency of 10 kHz or more from the viewpoint of heat-generating efficiency.

Heating is conducted by supplying an electric current to the coil 3 while controlling the supply in such a manner as to reach the vaporization temperature in the shortest possible time. Reduction of the heat capacity of the container is effective for increasing the rate of vaporization and, although it is advantageous not to make the container larger or the wall thicker than is necessary, a container of any size can be dealt with by increasing the current input. The power supply device 4 may have a controlling mechanism such as temperature controller for maintaining the rate of temperature rise and the preset temperature within the specified range. For this purpose, a thermocouple and the like may be installed in the container. The power supply device 4 is connected to a commercial power source and preferably performs the function of converting the commercial current to a high frequency current and supplying it to the induction coil and, at the same time, controls the supply of electric current in response to a signal from the thermocouple and the like.

When an organic material is vaporized by sublimation in a boat-shaped container and deposited on the substrate, the material vaporizes first from the center of the boat and the temperature of the boat is raised to vaporize the material around the center. In case the container is a cell, the material on the inner surface of the cell vaporizes forming a gap there and the temperature of the cell is raised to vaporize the material in the central part. It is the rate of vaporization or the actual film thickness that is monitored during this time and this monitoring procedure serves to control the power supply from the power supply device 4 and secure a uniform film thickness.

As noted above, an organic EL element has organic thin films such as a hole transport layer, a light-emitting layer and an electron transport layer between the anode and the cathode and the organic material 5 to be subjected to vapor deposition in this invention is used to form at least one kind of the aforementioned organic thin films.

The organic material for organic EL elements of this invention to be vaporized by electromagnetic induction heating may be applied to any one of hole transport materials, light-emitting materials, electron transport materials and the like. Examples of such organic materials are porphyrins, aromatic tertiary amines and styrylamines as hole transport material, tris(8-quinolinolato)aluminum, bis(benzoquinolinolato)beryllium and tri(dibenzoylmethyl)phenanthroline europium as light-emitting material and 1,3,4-oxazole derivatives and 1,2,4-triazole derivatives as electron transport material, but this invention is not limited to these examples and applicable to any organic compound which can be formed by vapor deposition into a thin film useful for organic EL elements. The method of this invention is also applicable effectively to multi-source vapor deposition where a precise control of the amount of deposited material is required.

The substrate holder 7 is placed in the chamber roughly right above the container 2 with the specified space left between them. The substrate 6 which constitutes an EL element is attached to the substrate holder 7 and the vaporized organic material is deposited on the surface of the substrate 6. As for the mechanism by which the substrate holder 7 holds the substrate 6, any known means such as suction and click can be adopted. If necessary, a cooling mechanism can be provided in the substrate holder 7. The substrate 6 is not restricted in its size and even a substrate whose length exceeds 500 mm may be used.

The method for vapor deposition by the use of the device of this invention will be described next.

The organic material 6 is introduced in the specified amount to the container 2. The substrate 6 on which several layers may already have been deposited by vapor deposition and the like is attached to the substrate holder 7 with the surface for deposition of film facing the container.

The device is then evacuated and heated to start vapor deposition. The temperature of the container 2 and the vaporizing part surrounding the container is so set that the organic material 5 produces the specified vapor pressure. Normally, this vapor pressure is in the range from several Torr to 10⁻⁸ Torr (from approximately 1×10² Pa to 1 × 10⁻⁶ Pa), but it is desirable to reduce the pressure inside the chamber to 1 × 10⁻⁶ Pa or less in order to lengthen the average free travel path of vaporized molecules. The temperature of the vaporizing part is maintained at the preset temperature by turning on and off the alternating current by means of a thermometer and a temperature controller or by utilizing inverter control.

The organic material introduced to the container vaporizes at the specified degree of vacuum and temperature and, for example, passes through a slit provided in the upper part of the container and deposits on the surface of the substrate to form a thin film.

### Examples

This invention will be described concretely below with reference to the examples.

### Example 1

The vapor deposition of tris(8-quinolinolato)aluminum (hereinafter referred to as Alq3) was carried out in the device shown in Fig. 1.

A cylindrical crucible constructed of a carbon steel tube, 15 mm in inside diameter and 25 mm in height, with its inner surface plated with molten aluminum was used as container 2. An alternating current of 200 V and 60 Hz for electromagnetic induction was supplied to the power supply device 4 equipped with a temperature controller and converted to high frequency by the use of an inverter.

In the container 2 was introduced 1 g of Alq3, the container 2 was heated with the temperature of the outer wall preset at 360 °C, the periphery of the chamber 1 was kept roughly at room temperature by contacting it with air of room temperature and the chamber was evacuated to 5×10⁻⁷ Torr by a vacuum pump.

A glass plate, 100 mm×100 mm, used as substrate 6 was placed approximately 350 mm above the container 2 and rotated. A monitor for film thickness was provided to measure the film-forming rate. The substrate was covered by a shutter until the film-forming rate measured by the monitor became constant, when the shutter was removed to start vapor deposition. Supply of electric power was controlled to obtain a film-forming rate of 0.3 nm/sec. An Alq3 film with a thickness of 50 nm was obtained after approximately 170 seconds. The film thickness varied ±5% over the whole area and ±1% in an area covering 50 mm×50 mm near the center.

### Example 2

A crucible, 15 mm in inside diameter and 25 mm in height, constructed of alumina-based ceramic was used as container 2. A filling up structure consisting of a bundle of 7 slender tubes (4.8 mm in outside diameter, 3.0 mm in inside diameter and 25 mm in height) constructed of ferrite-based stainless steel capable of generating heat by electromagnetic induction was placed in the container 2, 0.3 g of Alq3 was introduced to the container and vapor deposition was conducted under the same conditions as in Example 1. The film thickness was measured after the operation and good results were obtained as in Example 1. Fig. 2 is a perspective view of the aforementioned filling up structure and shows the arrangement of the tubes 8.

### Example 3

A crucible, 15 mm in inside diameter and 25 mm in height, constructed of ferrite-based stainless steel in the upper 5 mm and of alumina-based ceramic in the lower 20 mm was used as container 2. A filling up structure constructed of 9 100-mesh wire nettings arranged at intervals (20 mm in height and both sides of each netting coming into contact with the inner wall of the container 2 when put in place) was put in the container with its lower end reaching the bottom of the container, 0.3 g of Alq3 was introduced to the container and vapor deposition was conducted under the same conditions as in Example 1. The film thickness was measured after the operation and good results were obtained as in Example 1. Fig. 3 is a perspective view of the aforementioned filling up structure and shows the arrangement of the wire nettings 9.

### Industrial Applicability

As described above, it is possible by this invention to obtain a deposited film of good quality in high yield and productivity by heating a crucible-like container capable of holding a large amount of raw material and a filling up structure by electromagnetic induction uniformly and rapidly with good heat response and temperature control. As a result, it is possible to produce high-quality organic EL elements stably in high yield.

## Claims

1. In a method for vapor deposition of thin film for an organic EL element which comprises vaporizing an organic material for an EL element and depositing the vaporized organic material in thin film on the surface of a film-forming substrate, a method for producing an organic EL element which comprises introducing said organic material to a container constructed at least partly of a material capable of generating heat by electromagnetic induction and heating directly said container by electromagnetic induction thereby vaporizing the introduced organic material.

2. In the vapor deposition of thin film for an organic EL element which comprises vaporizing an organic material for an EL element in a container and depositing the vaporized organic material in thin film on the surface of a film-forming substrate, a device for vapor deposition of thin film for an organic EL element which comprises said container being constructed at least partly of a material capable of generating heat by electromagnetic induction, and a means for heating said container by electromagnetic induction to vaporize said organic material.

3. A device for vapor deposition of thin film for an organic EL element as described in claim 2 wherein at least the inner surface of the container is constructed of a material inert to the organic material to be vaporized.

4. A device for vapor deposition of thin film for an organic EL element as described in claim 2 wherein at least the bottom and the side of the container is constructed of a material capable of generating heat by electromagnetic induction.

5. In a method for vapor deposition of thin film for an organic EL element which comprises vaporizing an organic material for an EL element in a container and depositing the vaporized organic material in thin film on the surface of a film-forming substrate, a method for producing an organic EL element which comprises putting a filling up structure constructed at least partly of a material capable of generating heat by electromagnetic induction in the container to which said organic material is introduced and heating directly said filling up structure by electromagnetic induction to vaporize said organic material.

6. In vapor deposition of thin film for an organic EL element which comprises vaporizing an organic material for an EL element in a container and depositing the vaporized organic material in thin film on the surface of a film-forming substrate, a device for vapor deposition of thin film for an organic EL element which comprises said container to which said organic material is introduced together with a filling up structure constructed at least partly of a material capable of generating heat by electromagnetic induction and a means of heating said filling up structure by electromagnetic induction to vaporize said organic material.

7. A method for producing an organic EL element as described in claim 1 wherein the organic material is introduced to the container together with a filling up structure constructed at least partly of a material capable of generating heat by electromagnetic induction.

8. A device for vapor deposition of thin film for an organic EL element as described in claim 2 wherein the organic material is introduced to the container together with a filling up structure constructed at least partly of a material capable of generating heat by electromagnetic induction.
